(19) Europäisches Patentamt
European Patent Office
Office européen des brevets

(11) **EP 0 834 057 B1**

(12) # EUROPÄISCHE PATENTSCHRIFT

(45) Veröffentlichungstag und Bekanntmachung des Hinweises auf die Patenterteilung:
**27.03.2013 Patentblatt 2013/13**

(21) Anmeldenummer: **97925919.9**

(22) Anmeldetag: **17.04.1997**

(51) Int Cl.:
***G01F 1/60*** (2006.01) ***G01F 1/74*** (2006.01)

(86) Internationale Anmeldenummer:
**PCT/EP1997/001936**

(87) Internationale Veröffentlichungsnummer:
**WO 1997/039313 (23.10.1997 Gazette 1997/45)**

(54) **VORRICHTUNG ZUR BESTIMMUNG DES PHASENANTEILS EINES LEITFÄHIGEN MEDIUMS IN EINER LEITUNG**

DEVICE FOR DETERMINING THE PHASE COMPONENT OF A CONDUCTIVE MEDIUM IN A DUCT

DISPOSITIF POUR DETERMINER LA COMPOSANTE DE PHASE D'UN MILIEU CONDUCTEUR DANS UN CONDUIT

(84) Benannte Vertragsstaaten:
**CH DE FR GB LI**

(30) Priorität: **17.04.1996 DE 19615140**

(43) Veröffentlichungstag der Anmeldung:
**08.04.1998 Patentblatt 1998/15**

(73) Patentinhaber: **KROHNE MESSTECHNIK GMBH & CO. KG**
**47058 Duisburg (DE)**

(72) Erfinder: **BROCKHAUS, Helmut**
**D-46537 Dinslaken (DE)**

(74) Vertreter: **Gesthuysen, Hans Dieter et al**
**Patentanwälte**
**Gesthuysen, von Rohr & Eggert**
**Postfach 10 13 54**
**45013 Essen (DE)**

(56) Entgegenhaltungen:
**EP-A- 0 510 774      EP-A- 0 608 475**
**EP-A- 0 626 567      DE-A1- 3 810 034**
**DE-A1- 4 312 813     DE-B- 2 223 055**
**GB-A- 2 064 130      US-A- 3 639 835**
**US-A- 4 122 714**

• **BONFIG K.W. ET AL: 'Grundlagen', 01 Januar 1990, TECHNISCHE FUELLSTANDSMESSUNG UND GRENZSTANDSKONTROLLE - KONTAKT & STUDIUM, EXPERT VERLAG, DE, PAGE(S) 102 - 111, ISBN 978-3-8169-06 XP008117930**

EP 0 834 057 B1

## Beschreibung

Die Erfindung betrifft ein magnetisch-induktives Durchflussmessgerät mit einer ein leitfähiges Medium führenden Leitung und mit zwei der Durchflussmessung dienenden Elektroden, wobei eine der beiden Elektroden als Kondensatorplatte verwendet ist, zwischen dem Medium und der Kondensatorplatte eine Isolationsschicht vorgesehen ist sowie eine Steuer- und Auswerteschaltung vorhanden ist. Damit geht die Erfindung aus vom Stand der Technik aus der GB 2 064 130 A.

Im Übrigen sind im Stand der Technik Vorrichtungen zur Bestimmung des Phasenanteils eines leitfähigen Mediums in einer Leitung in Verbindung mit einem magnetisch-induktiven Durchflussmessgerät mit galvanisch gekoppelten Elektroden bekannt. Diese Vorrichtungen werden auch als Leerlauferkennungen bezeichnet. Bei einer solchen Leerlauferkennung wird gleichzeitig mit der normalen Durchflussmessung des magnetisch-induktiven Durchflussmessgeräts geprüft, ob die Leitung vollständig mit dem leitfähigen Medium gefüllt ist. Das Arbeitsprinzip dieser bekannten Leerlauferkennungen unterscheidet sich folglich von dem magnetisch-induktiven Durchflussmessgerät, von dem die Erfindung ausgeht, grundsätzlich.

Zum Stand der Technik gehören auch die EP 0 514 964 A und die GB 0 547 751 A. Daraus sind Verfahren und Vorrichtungen zur Bestimmung des Phasenanteils eines Mediums in einer Leitung bekannt. Bei diesen bekannten Verfahren und Vorrichtungen wird zur Bestimmung des Phasenanteils stets der Strom zwischen zwei Kondensatorplatten ausgewertet. Dies führt, wie aus den zuvor angegebenen Druckschriften ersichtlich, zu einer Aufteilung der Kondensatorplatten und einer relativ aufwendigen Ansteuerung der Kondensatorplatten und Auswertung der erzielten Messsignale. Diese Problematik resultiert aus der Tatsache, dass der Strom zwischen zwei Kondensatorplatten wesentlich von den elektrischen Eigenschaften des Mediums, also insbesondere der Dielektrizitätskonstante $\varepsilon$ und der elektrischen Leitfähigkeit $\sigma$, bestimmt wird.

Der Erfindung liegt folglich die Aufgabe zugrunde, ein magnetisch-induktives Durchflussmessgerät zur Verfügung zu stellen, mit dem nicht nur der Durchfluss des leitfähigen strömenden Mediums, sondern auch der Phasenanteil des leitfähigen Mediumsbestimmt werden kann.

Das erfindungsgemäße magnetisch-induktive Durchflussmessgerät, bei dem die zuvor hergeleitete und aufgezeigte Aufgabe gelöst ist, ist dadurch gekennzeichnet, dass mit dem Medium kapazitiv gekoppelte, vom Medium isolierte Elektroden, die nicht die der Durchflussmessung dienenden Elektroden sind, vorgesehen sind, dass die Steuer- und Auswerteschaltung die Kondensatorplatte mit einer zwischen der Kondensatorplatte und einem Bezugspotential wirksamen Wechselspannung beaufschlagt und die Kapazität eines durch das Medium und die Kondensatorplatte gebildeten Kondensators als Maß für den Phasenanteil des leitfähigen Mediums bestimmt wird und dass das Medium über die kapazitiv gekoppelten, vom Medium isolierten Elektroden, die nicht die der Durchflussmessung dienenden Elektroden sind, mit dem Bezugspotential verbunden ist.

Bei vollständig gefüllter Leitung bildet sich zwischen der Kondensatorplatte mit einer Oberfläche A und dem leitfähigen Medium eine Kapazität. Ist die Leitung nun nicht mehr vollständig gefüllt, ergibt sich eine kleinere Kapazität $C_{Me\beta}$, die proportional zu einer kleineren Fläche $A'$ ist. Die kleinere Fläche $A'$ erhält man durch die Projektion der Fläche $A$ von der Außenseite der Leitung auf die Innenseite und die Betrachtung nur des Teils dieser Fläche, der mit dem leitfähigen Medium benetzt ist. Bezeichnet man die mittlere Dicke der Isolationsschicht zwischen der Kondensatorplatte und dem leitfähigen Medium mit d und die Dielektrizitätskonstante dieser Schicht mit $\varepsilon$, so erhält man für $C_{Me\beta}$:

$$C_{Me\beta} = \varepsilon \frac{A}{d}$$

und für $C'_{Me\beta}$:

$$C'_{Me\beta} = \varepsilon \frac{A'}{d}$$

Hieraus erkennt man, dass die Kapazität zwischen der Kondensatorplate und dem Medium ohne weiteres als Maß für den Phasenanteil des leitfähigen Mediums in der Leitung geeignet ist.

Gemäß einer ersten Ausgestaltung der erfindungsgemäßen Lehre führt die Steuer- und Auswerteschaltung anhand der gemessenen Kapazität zwischen der Kondensatorplatte und dem Medium eine Schwellwertentscheidung durch. Beim Unterschreiten des Schwellwertes wird in bekannter Art und Weise ein Leerlaufsignal ausgegeben.

Alternativ oder kumulativ zu der an sich bekannten Leerlauferkennung ist die erfindungsgemäße Lehre dadurch weiter ausgestaltet, dass die Steuer- und Auswerteschaltung die Kapazität zwischen der Kondensatorplatte und dem Medium quantitativ auswertet, d. h. ein zur Füllstandshöhe des Mediums in der Leitung proportionales Signal ausgibt. Somit ist bei der Kombination der erfindungsgemäßen Vorrichtung mit einem MID auch bei einer nur teilweise gefüllten Leitung sichergestellt, dass die Durchflussmenge zutreffend feststellbar ist.

Nach einer alternativen Ausgestaltung der erfindungsgemäßen Lehre liegt die Wechselspannung zwischen jeweils einer Kondensatorplatte und einem Bezugspotential an, mit dem das Medium mit Hilfe eines Mittels zur Erdung verbunden ist. Diese Ausgestaltung gewährleistet eine Realisierung der erfindungsgemäßen Vorrichtung mit nur einer Kondensatorplatte.

Eine weitere Ausgestaltung erfährt das erfindungsgemäße magentisch-induktive Durchflussmessgerät dadurch, dass die Kapazität zwischen der Kondensatorplatte und dem Medium eine erste Kapazität eines mindestens zwei Kapazitäten aufweisenden kapazitiven Spannungsteilers bildet und die Steuer- und Auswerteschaltung das Messsignal am Mittelabgriff des kapazitiven Spannungsteilers abgreift. Bei dieser Ausgestaltung der erfindungsgemäßen Lehre liegt das Wechselspannungssignal $S_{Test}$ über die zweite Kapazität des kapazitiven Spannungsteilers an der Kapazität zwischen der Kondensatorplatte und dem Medium an. Es ergibt sich somit für die von der Steuer- und Auswerteschaltung ausgewertete Spannung $U_{Test}$ folgender Zusammenhang:

$$U_{Test} = S_{Test} \frac{C_{Test}}{C_{Test} + C'_{Meß}}$$

mit

$C_{Test}$ = zweite Kapazität des kapazitiven Spannungsteilers.

Diese Ausgestaltung des erfindungsgemäßen magnetisch-induktiven Durchflussmessgeräts ist vorteilhaft, da somit eine besonders einfach zu realisierende Möglichkeit der Messung der Kapazität zwischen der Kondensatorplatte und dem Medium zur Verfügung gestellt ist.

Die zuletzt beschriebene Anordnung erfährt eine weitere vorteilhafte Ausgestaltung dadurch, dass die zweite Kapazität $C_{Test}$ des kapazitiven Spannungsteilers kleiner als die erste Kapazität $C'_{Meß}$ ist. Bei leerer Leitung ist dann die Spannung $U_{Test}$ groß, da $C_{Meß}$ fast gleich Null ist. Hingegen ist bei voller Leitung die Spannung $U_{Test}$ klein, da $C'_{Meß}$ deutlich größer als $C_{Test}$ ist,

Eine, wie vorgeschlagen, kleine zweite Kapazität $C_{Test}$ lässt sich ohne schaltungstechnischen Aufwand besonders einfach dadurch zur Verfügung stellen, dass eine parasitäre Kapazität der Steuer- und Auswerteschaltung diese zweite Kapazität $C_{Test}$ bildet.

Im Einzelnen gibt es nun eine Vielzahl von Möglichkeiten, das erfindungsgemäße magnetisch-induktive Durchflussmessgerät auszugestalten und weiterzubilden. Dazu wird verwiesen einerseits auf die dem Patentanspruch 1 nachgeordneten Patentansprüche, andererseits auf die Beschreibung von bevorzugten Ausführungsbeispielen in Verbindung mit der Zeichnung. In der Zeichnung zeigt

Fig. 1    die prinzipielle Ausbildung eines magnetisch-induktiven Durchflussmessgerätes sowohl mit kapazitiv gekoppelten Elektroden als auch mit galvanisch gekoppelten Elektroden,

Fig. 2    ein erstes Ausführungsbeispiel eines erfindungsgemäßen magnetisch-induktiven Durchflussmessgerätes, dargestellt in Verbindung mit einer vollständig gefüllten Leitung,

Fig. 3    das Ausführungsbeispiel eines erfindungsgemäßen magnetisch-induktiven Durchflussmessgerätes nach Fig. 2, dargestellt in Verbindung mit einer teilweise gefüllten Leitung,

Fig. 4    ein zweites Ausführungsbeispiel eines erfindungsgemäßen magnetisch-induktiven Durchflussmessgerätes, dargestellt wiederum mit einer teilweise gefüllten Leitung.

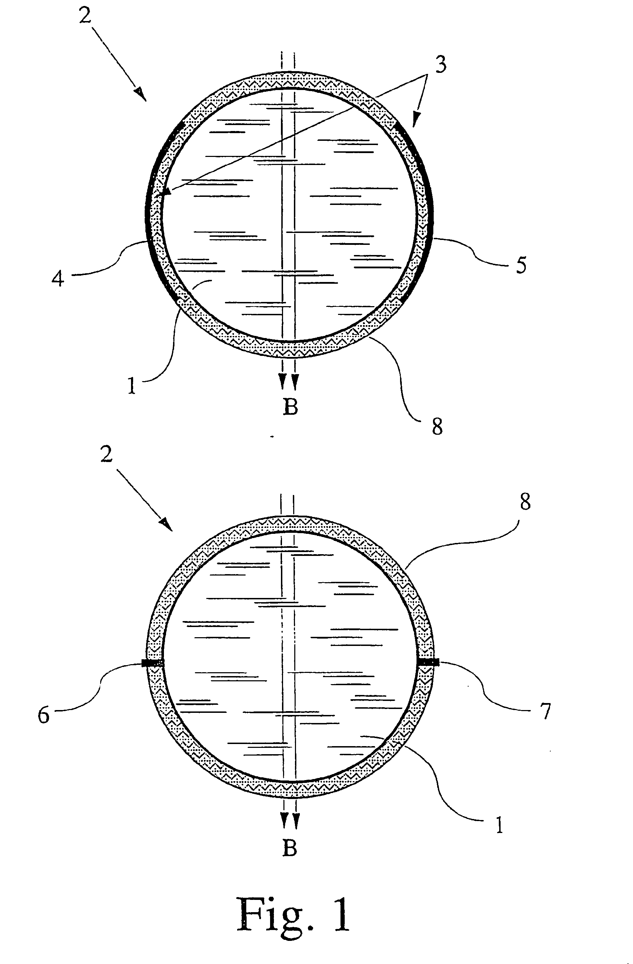

Es soll zunächst das Prinzip eines magnetisch-induktiven Durchflussmessgerätes anhand der Fig. 1 der Zeichnung erläutert werden.

Ein magnetisch-induktiven Durchflussmessgeräte besteht zunächst aus einer ein leitfähiges Medium 1 führenden Leitung 2. In der Leitung 2 wird ein magnetisches Wechselfeld B mit einer Frequenz $f_{Meß}$ erzeugt, dessen magnetische Feldlinien im Wesentlichen senkrecht zur Leitungsachse verlaufen. Durch die Lorenzkraft wird, abhängig von der Durchflussgeschwindigkeit v des leitfähigen Mediums eine Ladungstrennung in dem Medium erzeugt. An zwei Elektroden 4, 5, bzw. 6, 7, deren Elektrodenachse sowohl senkrecht zu den magnetischen Feldlinien als auch zu der Leitungsachse liegt, kann eine Wechselspannung $U_{Meß}$ mit der Messfrequenz $f_{Meß}$ gemessen werden, deren Amplitude proportional zur Durchflussgeschwindigkeit v des Mediums 1 in der Leitung 2 ist. Bei einem magnetisch-induktiven Durchflussmessgerät mit galvanisch gekoppelten Elektroden 6, 7 wird diese Spannung $U_{Meß}$ über metallische Kontakte zu dem Medium 1 nahezu punktförmig abgegriffen. Bei magnetisch-induktiven Durchflussmessgeräten mit kapazitiv gekoppelten Elektroden 4, 5, die bei der vorliegenden Erfindung gleichzeitig als Kondensatorplatten dienen können, wird die Wechselspannung $U_{Meß}$ zwischen flächenförmigen Elektroden 4, 5, die von dem leitfähigen Medium durch eine Isolationsschicht 8 getrennt sind, kapazitiv abgegriffen. Die Leitung 2 ist auch bei einem magnetisch-induktiven Durchflussmessgerät mit galvanisch gekoppelten Elektroden 6, 7 mit einer Isolationsschicht 8 ausgekleidet, die jedoch von den galvanisch gekoppelten Elektroden 6, 7 durchbrochen ist. Bei beiden Varianten der bekannten magnetisch-induktiven Durchflussmessgeräte wird das leitfähige Medium außerhalb des gegenüber der Flüssigkeit isolierten Leitungsabschnittes mit einem Bezugspotential, beispielsweise über Erdungsringe oder metallische Rohrstücke, verbunden.

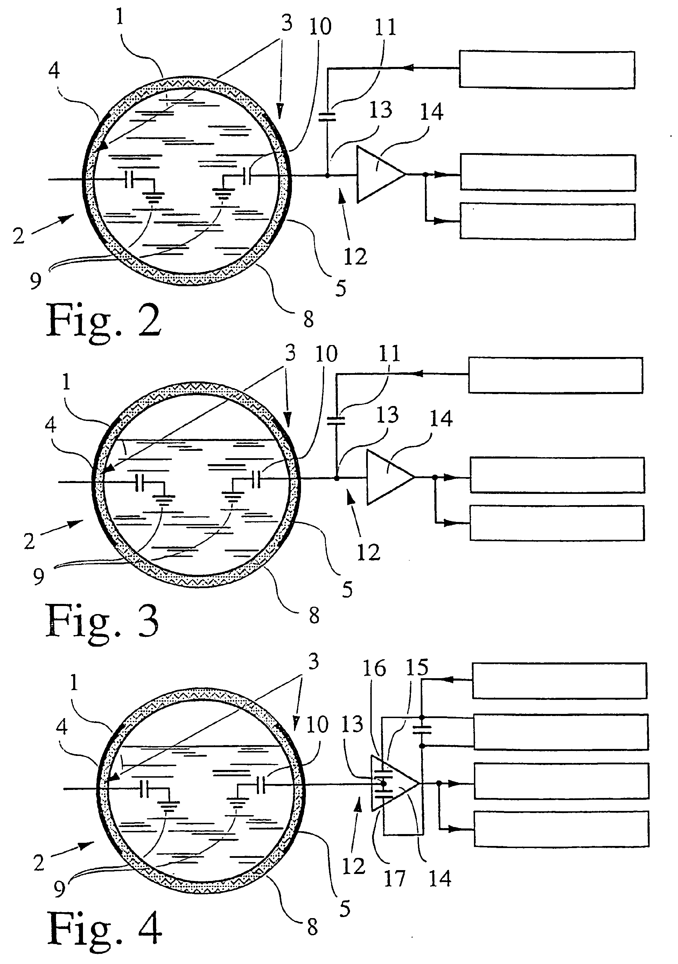

Fig. 2 der Zeichnung zeigt ein erstes Ausführungsbeispiel eines erfindungsgemäßen magnetisch-induktiven Durchflussmessgeräts zur Bestimmung des Phasenanteils eines leitfähigen Mediums in einer Leitung 2. In der Fig. 2 ist die Leitung 2 vollständig mit dem leitfähigen Medium 1 gefüllt. Somit kommt die gesamte Oberfläche der Kondensatorplatten 3, also der Elektroden 4, 5, für die Kapazität zwischen den Kondensatorplatten 3 und dem leitfähigen Medium 1 zum Tragen. Für die Kapazität $C_{Me\beta}$ ergibt sich also:

$$C_{Me\beta} = \varepsilon \frac{A}{d}$$

Im dargestellten ersten Ausführungsbeispiel eines erfindungsgemäßen magnetisch-induktiven Durchflussmessgeräts wird diese Kapazität $C_{Me\beta}$ dadurch bestimmt, dass eine Wechselspannung $S_{Test}$ zwischen jeweils einer Kondensatorplatte 3, also einer Elektrode 4 bzw. 5, und einem Bezugspotential 9 anliegt und dass das Medium 1 mit Hilfe eines nicht dargestellten Mittels zur Erdung mit dem Bezugspotential 9 verbunden ist. Bei dem in Fig. 2 dargestellten ersten Ausführungsbeispiel eines erfindungsgemäßen magnetisch-induktiven Durchflussmessgeräts ist die Steuer- und Auswerteschaltung nur für die rechte Elektrode 5 dargestellt. Sollte auch die linke Elektrode 4 zur Bestimmung des Phasenanteils des leitfähigen Mediums 1 herangezogen werden, so ist eine entsprechende Steuer- und Auswerteschaltung mit der linken Elektrode 4 zu verbinden.

Bei dem in Fig. 2 dargestellten ersten Ausführungsbeispiel eines erfindungsgemäßen magnetisch-induktiven Durchflussmessgeräts bildet die Kapazität $C_{Me\beta}$ zwischen der als Kondensatorplatte 3 dienenden Elektrode 4 und dem Medium 1 eine erste Kapazität 10 eines zwei Kapazitäten 10, 11 aufweisenden kapazitiven Spannungsteilers 12. Die Steuer- und Auswerteschaltung greift hier das Messsignal am Mittelabgriff 13 des kapazitiven Spannungsteilers 12 ab und ermittelt aus dem am Ausgang eines Buffers 14 anliegenden Signal die Testspannung $U_{Test}$ und damit den Phasenanteil des leitfähigen Mediums 1 in der Leitung 2 und die Messspannung $U_{Me\beta}$ und damit die Durchflussgeschwindigkeit V des Mediums 1 in der Leitung 2. Aus diesen beiden Größen kann die Steuer- und Auswerteschaltung anschließend die Durchflussmenge durch die Leitung 2 bestimmen. Bei der dargestellten vollständig gefüllten Leitung 2 ergibt sich die Durchflussmenge in bekannter Weise aus der Durchflussgeschwindigkeit V multipliziert mit dem Querschnitt der Leitung 2.

Die Fig. 3 der Zeichnung zeigt nun das erste Ausführungsbeispiel eines erfindungsgemäßen magnetisch-induktiven Durchflussmessgeräts mit einer nur teilweise gefüllten Leitung 2. Der von dem erfindungsgemäßen magnetisch-induktiven Durchflussmessgerät bestimmte Phasenanteil des flüssigen leitfähigen Mediums 1 ist somit geringer als 1. Dies drückt sich messtechnisch darin aus, dass die wirksame Fläche A' der Kapazität der als Elektrode 5 dienenden Kondensatorplatte 3 deutlich geringer ist als die Gesamtfläche der gleichzeitig als Elektrode 5 wirkenden Kondensatorplatte 3. Für die Kapazität $C'_{Me\beta}$ ergibt sich somit:

$$C'_{Me\beta} = \varepsilon \frac{A'}{d}$$

Die Kapazität $C'_{Me\beta}$ bildet in Fig. 3 wiederum die erste Kapazität 10 eines Spannungsteilers 12. Die Steuer- und Auswerteschaltung ermittelt die Kapazität zwischen der Kondensatorplatte 3 und dem Medium 1, wie bereits anhand von Fig. 2 beschrieben. Die durch die Leitung 2 strömende Menge des Mediums 1 ergibt sich bei einer nur teilweisen Füllung der Leitung 1, wie in Fig. 3 dargestellt, aus der Durchflussgeschwindigkeit V, multipliziert mit dem Querschnitt der Leitung 2 und dem Phasenanteil des leitfähigen Mediums 1, der sich aus der Kapazität $C_{Me\beta}$ bestimmen lässt.

Fig. 4 der Zeichnung zeigt ein zweites Ausführungsbeispiel eines erfindungsgemäßen magnetisch-induktiven Durchflussmessgeräts, bei der eine parasitäre Kapazität 15 des Buffers 14 der Steuer- und Auswerteschaltung die zweite Kapazität eines kapazitiven Spannungsteilers 12 bildet. Die parasitäre Kapazität 15 wird hierbei durch einen parasitären Kondensator zwischen dem Eingang des Buffers 14 und dessen Versorgungsanschlüssen 16, 17 gebildet. Ansonsten stimmt die Funktionsweise des in Fig. 4 dargestellten zweiten Ausführungsbeispiels eines erfindungsgemäßen magnetisch-induktiven Durchflussmessgeräts mit der des in den Fig. 2 und 3 dargestellten ersten Ausführungsbeispiels überein.

Wird die Wechselspannung, wie in der allgemeinen Beschreibung bereits erläutert, zwischen zwei Kondensatorplatten über ein Differenzsignal eingespeist, so wird die Testspannung in diesem Fall zwischen zwei Buffern abgenommen. Die Funktion stimmt ansonsten im Wesentlichen mit der der in den Fig. 2 bis 4 beschriebenen Ausführungsbeispielen überein.

Beim Betrieb eines erfindungsgemäßen magnetisch-induktiven Durchflussmessgeräts zur Bestimmung des Phasenanteils eines leitfähigen Mediums 1 in einer Leitung 2 in Verbindung mit einem magnetisch-induktiven Durchflussmessgerät, wie in den Fig. 2 bis 4 dargestellt, ist zu beachten, dass die von der Steuer- und Auswerteschaltung an die Kondensatorplatten angelegte Wechselspannung eine von der Frequenz des magnetischen Wechselfeldes B, $f_{Me\beta}$, verschiedene Frequenz $f_{Test}$ aufweisen muss.

**Patentansprüche**

1. Magnetisch-induktives Durchflussmessgerät mit einer ein leitfähiges Medium (1) führenden Leitung (2) und mit zwei der Durchflussmessung dienenden Elektroden (4, 5), wobei eine der beiden Elektroden (4 oder 5) als Kondensatorplatte (3) verwendet ist, zwischen dem Medium (1) und der Kondensatorplatte (3) eine Isolationsschicht (8) vorgesehen ist sowie eine Steuer- und Auswerteschaltung vorhanden ist, **dadurch gekennzeichnet,**

**dass** mit dem Medium (1) kapazitiv gekoppelte, vom Medium (1) isolierte Elektroden, die nicht die der Durchflussmessung dienenden Elektroden (4, 5) sind, vorgesehen sind, dass die Steuer- und Auswerteschaltung die Kondensatorplatte (3) mit einer zwischen der Kondensatorplatte (3) und einem Bezugspotential (9) wirksamen Wechselspannung beaufschlagt und die Kapazität eines durch das Medium (1) und die Kondensatorplatte (3) gebildeten Kondensators als Maß für den Phasenanteil des leitfähigen Mediums bestimmt wird und dass das Medium (1) über die kapazitiv gekoppelten, vom Medium (1) isolierten Elektroden, die nicht die der Durchflussmessung dienenden Elektroden sind, mit dem Bezugspotential (9) verbunden ist.

2. Magnetisch-induktives Durchflussmessgerät nach Anspruch 1, **dadurch gekennzeichnet, dass** der Kondensator zwischen dem Medium (1) und der Kondensatorplatte (3) einen ersten Kondensator (10) eines zwei Kondensatoren (10, 11) aufweisenden kapazitiven Spannungsteilers (12) bildet und die Steuer- und Auswerteschaltung das Messsignal am Mittelabgriff (13) des kapazitiven Spannungsteilers (12) abgreift,

3. Magnetisch-induktives Durchflussmessgerät nach Anspruch 2, **dadurch gekennzeichnet, dass** die Kapazität des zweiten Kondensators (11) des kapazitiven Spannungsteilers (12) kleiner ist als die Kapazität des ersten Kondensators (10).

4. Vorrichtung nach Anspruch 2 oder 3, **dadurch gekennzeichnet, dass** eine parasitäre Kapazität (15) der Steuer- und Auswerteschaltung den zweiten Kondensator bildet.

**Claims**

1. Magneto-inductive flowmeter with a line (2) guiding a conductive medium (1) and with two electrodes (4, 5) used for flow measurement, wherein one of the two electrodes (4 or 5) is used as a capacitor plate (3), an insulating layer (8) is provided between the medium (1) and the capacitor plate (3), and a control and evaluation circuit is also provided, **characterized in**

**that** electrodes insulated from the medium (1), capacitively coupled with the medium (1), which are not electrodes (4, 5) used for flow measurement, are provided, that the control and evaluation circuit applies an alternating voltage effective between the capacitor plate (3) and a reference potential (9) to the capacitor plate (3) and the capacitance of a capacitor formed by the medium (1) and the capacitor plate (3) is determined as a measure of the phase portion of the conductive medium, and that the medium (1) is connected to the reference potential (9) via the capacitively coupled electrodes insulated from the medium (1), which are not electrodes used for flow measurement.

2. Magneto-inductive flowmeter according to claim 1, **characterized in that** the capacitor between the medium (1) and the capacitor plate (3) forms a first capacitor (10) of a capacitive voltage divider (12) having two capacitors (10, 11) and the control and evaluation circuit taps the measurement signal on the middle tap (13) of the capacitive voltage divider.

3. Magneto-inductive flowmeter according to claim 2, **characterized in that** the capacitance of the second capacitor (11) of the capacitive voltage divider (12) is less than the capacitance of the first capacitor (10).

4. Device according to claim 2 or 3, **characterized in that** a parasitic capacitance (15) of the control and evaluation circuit forms the second capacitor.

**Revendications**

1. Débitmètre à induction magnétique présentant un conduit (2) qui transporte un fluide conducteur (1) et deux électrodes (4, 5) qui servent à mesurer le débit, l'une des deux électrodes (4 ou 5) étant utilisée comme plaque de condensateur (3), une couche isolante (8) étant prévue entre le fluide (1) et la plaque de condensateur (3) et un circuit de commande et d'évaluation étant présent **caractérisé en ce que**

le détecteur présente des électrodes couplées capacitivement au fluide (1) et isolées du fluide (1), qui ne sont pas les électrodes (4, 5) qui servent à la mesure du débit,

**en ce que** le circuit de commande et d'évaluation applique une tension alternative entre la plaque de condensateur (3) et un potentiel de référence (9) sur la plaque de condensateur (3),

**en ce que** la capacité du condensateur formé par le fluide (1) et la plaque de condensateur (3) est déterminée comme mesure de la fraction de phase du fluide conducteur et

**en ce que** le fluide (1) est relié au potentiel de référence (9) par l'intermédiaire des électrodes couplées capacitivement, isolées du fluide (1) et qui ne sont pas les électrodes qui servent à la mesure du débit.

2. Débitmètre à induction magnétique selon la revendication 1, **caractérisé en ce que** le condensateur forme entre le fluide (1) et la plaque de condensateur (3) un premier condensateur (10) d'un diviseur capacitif de tension (12) qui présente deux condensateurs (10, 11) et **en ce que** le circuit de commande et d'évaluation saisit le signal de mesure sur la borne centrale (13) du diviseur capacitif de tension (12).

3. Débitmètre à induction magnétique selon la revendication 2, **caractérisé en ce que** la capacité du deuxième condensateur (11) du diviseur capacitif de tension (12) est inférieure à la capacité du premier condensateur (10).

4. Dispositif selon les revendications 2 ou 3, **caractérisé en ce qu'**une capacité parasite (15) du circuit de commande et d'évaluation forme le deuxième condensateur.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2064130 A
- EP 0514964 A
- GB 0547751 A